# EUROPEAN PATENT APPLICATION

(11) **EP 1 662 590 A1**
(43) Date of publication of application: **31.05.2006**
(21) Application number: 05110625.0
(22) Date of filing: 11.11.2005
(51) Int. Cl.: H01L 51/52, H01L 51/56

(54) **Electroluminescent display device and method of manufacturing the same**

(30) Priority: 25.11.2004 KR 200497510
(71) Applicant: Samsung SDI Co., Ltd., Suwon-si Gyeonggi-do (KR)
(72) Inventor: Kim, Jong-Jin, Suwon-shi, Gyeonggi-do (KR)
(74) Representative: Hengelhaupt, Jürgen

(57) **Abstract**

An electroluminescent display device and a method of manufacturing the same are provided. The electroluminescent display device includes a substrate having a display region and a terminal unit; a sealing substrate arranged above the substrate; and an encapsulant arranged on at least a portion of an edge of the substrate to seal at least the display region.

## Description

### CROSS REFERENCE TO RELATED APPLICATION

This application claims priority to and the benefit of Korean Patent Application No. 10-2004-0097510, filed on November 25, 2004, which is hereby incorporated by reference for all purposes as if fully set forth herein.

### BACKGROUND OF THE INVENTION

### Field of the Invention

The invention relates to an electroluminescent display device, and more particularly, to an electroluminescent display device having a wide region where an encapsulant is disposed, which decreases and/or prevents deterioration caused by moisture, leakage, or the like.

### Description of the Related Art

Flat display devices including liquid crystal display devices, organic electroluminescent devices, inorganic electroluminescent devices, and the like are categorized into passive matrix (PM) displays and active matrix (AM) displays according to a type of driving method used therewith. In PM flat display devices, anodes may form columns and cathodes may form rows. A row driving circuit supplies a scanning signal to one of the rows, thereby selecting said row, and a column driving circuit supplies a data signal to each pixel of the selected row. Alternatively, in AM flat display devices, a thin film transistor (TFT) controls an input signal of each pixel. Therefore, AM flat display devices are suitable for processing a sufficiently large amount of signals, thus having a competitive edge over PM flat displays for displaying moving images.

For example, among flat display devices, an organic electroluminescent display device includes an organic emission layer having an organic material formed between an anode and a cathode. When an anode voltage and a cathode voltage are applied to the anode and the cathode, respectively, holes injected from the anode move to the organic emission layer through a hole transport layer and electrons injected from the cathode move to the organic emission layer through an electron transport layer. In the organic emission layer, the holes and electrons recombine to generate excitons. The excitons drop from an exited state to a ground state. Therefore, luminous molecules of the organic emission layer emit light, thus forming an image. In order to form a full-color image, an organic electroluminescent display device includes pixels emitting color; e.g., a red (R) color, a green (G) color, and a blue (B) color.

According to a conventional method of manufacturing an electroluminescent display device, a mother substrate having a plurality of display regions and a sealing mother substrate are coupled together to form entirely integrated display regions. The integrated display regions are scribed, thus forming individual display devices.

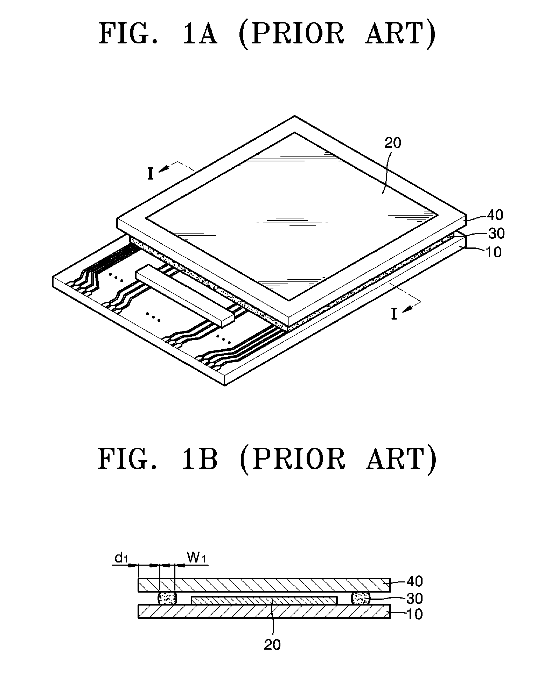

FIG. 1A is a perspective view of a conventional electroluminescent display device, and FIG. 1B is a sectional view taken along line I - I in FIG. 1A. Referring to FIG. 1A and FIG. 1B, a display region 20 is formed on a surface of a substrate 10, and sealed between the substrate 10 and a sealing substrate 40 by an encapsulant 30.

Such an electroluminescent display device can be obtained by scribing, e.g., cutting a grid-like pattern, the mother substrate and the sealing mother substrate. The encapsulant 30 arranged between the mother substrate 10 and the sealing substrate 40 is positioned between a scribing region d1 and the display region 20. The encapsulant 30 has a predetermined width w1 and may be arranged in a limited region of the electroluminescent display device. In addition, a subsequent process for hardening the encapsulant 30 results in an additional expansion of the encapsulant 30. Therefore, due to such expansion, a region where the encapsulant 30 is initially formed must be reduced. In addition, the encapsulant 30 may overflow into the display region 20 when the region for the encapsulant 30 is increased to increase sealing ability.

### SUMMARY OF THE INVENTION

The invention provides an electroluminescent display device with a sufficiently wide region where an encapsulant is disposed, thus having improved sealing properties relative to a conventional electroluminescent display device, and a method of manufacturing the same.

Additional features of the invention will be set forth in the description which follows, and in part will be apparent from the description, or may be learned by practice of the invention.

The present invention discloses an electroluminescent display device, including a substrate comprising a display region and a terminal unit; a sealing substrate arranged above the substrate; and an encapsulant arranged at an edge region of the substrate and sealed with the display region.

The present invention also discloses a method of manufacturing an electroluminescent display device, including forming a display region on a mother substrate; forming an encapsulant on a portion of a scribed region on a sealing mother substrate; hardening the encapsulant; sealing the mother substrate with the sealing mother substrate; and cutting the mother substrate and the sealing mother substrate along the scribed region.

It is to be understood that both the foregoing general description and the following detailed description are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

FIG. 1A is a perspective view of a conventional electroluminescent display device.

FIG. 1B is a sectional view taken along line I - I shown in FIG. 1A.

FIG. 2A is a perspective view of an electroluminescent display device according to an embodiment of the invention.

FIG. 2B is a plan view of a pixel of a portion "A" shown in FIG. 2A.

FIG. 2C is a sectional view taken along line II - II shown in FIG. 2B.

FIG. 2D is a sectional view taken along line II - II shown in FIG. 2A.

FIGS. 3A, 3B, 3C, and 3D are sectional views showing a method of manufacturing an organic electroluminescent display device including a sealing layer according to an embodiment of the invention.

FIG. 4A and FIG. 4B are sectional views showing methods of manufacturing organic electroluminescent display devices including sealing layers according to other embodiments of the invention.

### DESCRIPTION OF THE ILLUSTRATED EMBODIMENTS

The invention is described more fully hereinafter with reference to the accompanying drawings, in which embodiments of the invention are shown. This invention may, however, be embodied in many different forms and should not be construed as limited to the embodiments set forth herein. Rather, these embodiments are provided so that this disclosure is thorough, and will fully convey the scope of the invention to those skilled in the art. In the drawings, the size and relative sizes of layers and regions may be exaggerated for clarity.

It is understood that when an element or layer is referred to as being "on" or "connected to" or "connected with" another element or layer, it can be directly on or directly connected to or with the other element or layer or intervening elements or layers may be present.

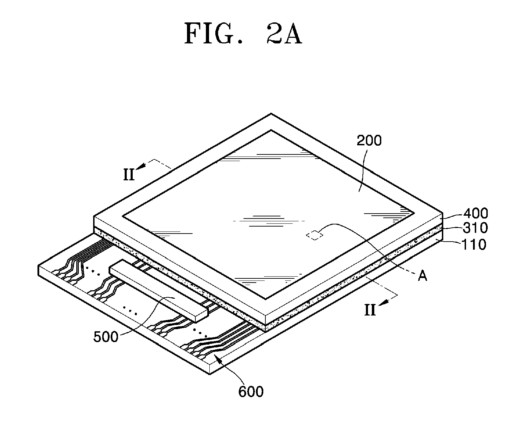

FIG. 2A is a perspective view of an electroluminescent display device according to an embodiment of the invention. Referring to FIG. 2A, a display region 200 including at least one pixel is arranged on a substrate 110. A pad unit 600 including at least a terminal is arranged outside of the display region 200. An encapsulant 310 is arranged between the display region 200 and the pad unit 600. The substrate 110 and a sealing substrate 400 are sealed together by at least the encapsulant 310, resulting in a sealed space that includes at least the display region 200. As illustrated in FIG. 2A, the encapsulant 310 is arranged on at least a portion of an edge area of the substrate 110.

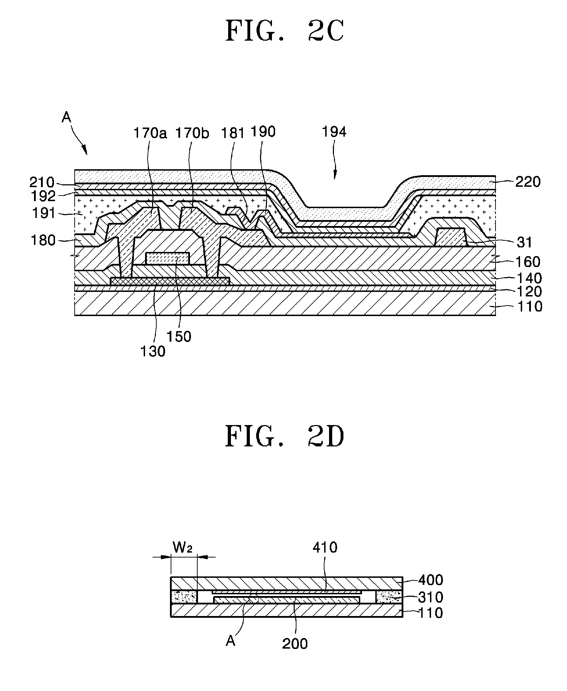

An absorbing layer 410 (shown in FIG. 2D) may be arranged in the sealed space to absorb moisture or the like, thus reducing the risk of damage to an organic electroluminescent emission unit. The absorbing layer 410 may be composed of Ba, active alumina, or an alkali earth peroxide, such as kalium oxide or barium oxide.

Meanwhile, an electric device that transmits an electric signal to the organic electroluminescent display region 200 may be arranged in the sealing region formed between the display region 200 and a sealing unit. Alternatively, the electric device, which may be a horizontal driving circuit 500 as shown in FIG. 2A, may be arranged outside of the sealing region. For example, the electric device may be a vertical/horizontal driving circuit unit such as a scan driver/data driver that transmits a scan signal and/or a data signal to a pixel of the display region 200. Such a vertical/horizontal circuit unit is disposed on a chip on glass (COG), a flexible printed circuit (FPC), or the like.

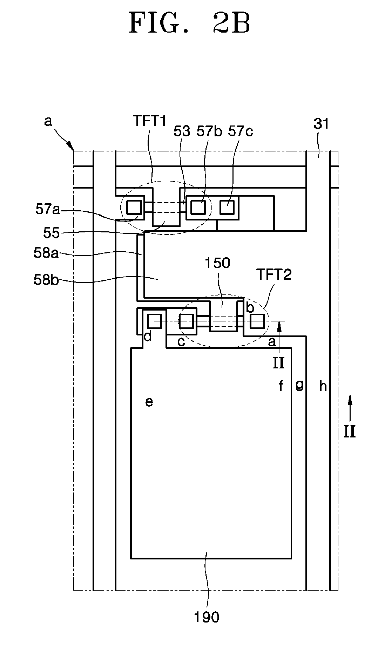

FIG. 2B is a plan view of a pixel of a portion "A" shown in FIG. 2A. Referring to FIG. 2B, the pixel includes two top-gate type thin film transistors (TFTs) and a capacitor, but is not limited thereto.

A gate electrode 55 of TFT1, e.g., a first TFT, which selects a pixel, extends from a scan line that applies a scan signal. When an electric signal, such as a scan signal, is applied to the scan line, a data signal input through a data line is transferred from a source electrode 57a of the TFT1 to a drain electrode 57b of the TFT1 through a semiconductor active layer 53.

An extended portion 57c of the drain electrode 57b of the first TFT TFT1 is connected, e.g., coupled, with an end of a first electrode 58a of a capacitor. The other end of the first electrode 58a of the capacitor forms a gate electrode 150 of TFT2, e.g., a second TFT, which is a driving TFT. The second electrode 58b of the capacitor is electrically connected, e.g.., coupled, with a driving line 31 that is coupled with a driving power supply line (not shown).

FIG. 2C is a sectional view taken along line II - II shown in FIG. 2B. A sectional view through points (a)-(e) of the line II - II illustrates TFT2, which is a driving thin film transistor. A sectional view through points (e)-(f) illustrates a pixel opening 194. A sectional view through points (g)-(h) illustrates a driving line.

Referring to FIG. 2C, in the TFT2, a buffer layer 120 is arranged on a surface of the substrate 110, and a semiconductor active layer 130 of the TFT2 is arranged on the buffer layer 120. The semiconductor active layer 130 may include amorphous silicon or polycrystal silicon. The semiconductor active layer 130 may include a source region and a drain region respectively doped with an N+ type dopant or a P+ type dopant and a channel region, which are not shown in FIG. 2C. The semiconductor active layer 130 may be an organic semiconductor, but is not limited thereto.

A gate electrode 150 of the TFT2 is arranged over the semiconductor active layer 130. A material of the gate electrode 150 is selected according to various criteria, such as adherence to an adjacent layer, smoothness of a layer to be deposited, ease of processing, etc. The gate electrode 150 may include MoW, Al/Cu, or the like, but is not limited thereto.

The gate electrode 150 is insulated from the semiconductor active layer 130 by a gate insulator 140 arranged therebetween. An interlayer 160 acting as an insulator may be formed on the gate electrode 150 and the gate insulator 140. The interlayer 160 may be a single layer and/or a plurality of layers. A source electrode 170a and a drain electrode 170b of the TFT2 are arranged on the interlayer 160. The source electrode 170a and the drain electrode 170b may be formed of a metal, such as MoW or the like, and may be subsequently thermally treated, e.g., heat treated, such that the source electrode 170a and the drain electrode 170b form a smooth ohmic contact with the semiconductor active layer 130.

A protecting layer 180 is formed on the source and drain electrodes 170a and 170b. The protecting layer 180 may operate as a passivation layer and/or a planarization layer for protection and/or planarization. A first electrode layer 190 is arranged on the protecting layer 180, and is electrically connected, e.g., coupled, with the source electrode 170a and the drain electrode 170b through a via hole 181 that is formed in the protecting layer 180. For example, in a rear emission type display, the first electrode layer 190 may be made of a transparent material, such as indium-tin-oxide (ITO) or the like. Alternatively, in a front emission type display, the first electrode layer 190 may be made of a reflecting material such as Al/Ca, or a transparent material such as ITO or the like. Although in the embodiment discussed above and shown in FIGS. 2A, 2B, 2C, and 2D, the first electrode 190 is an anode electrode, it is understood that the first electrode 190 may be as a cathode electrode in other embodiments of the invention.

The protecting layer 180 may have various structures. For example, the protecting layer 180 may be made of an inorganic material or an organic material. In addition, the protecting layer 180 may be a single layer or a double layer. When the protecting layer 180 is a double layer, a lower layer may include SiNx and an upper layer may include an organic material, such as benzocyclobutene (BCB), acryl, or the like.

A pixel defining layer 191 is arranged on the protecting layer 180; however, the pixel defining layer 191 is not arranged at a pixel opening 194 corresponding to the first electrode layer 190 to define a pixel. An organic electroluminescent emission unit 192 including an emission layer is arranged on the first electrode 190.

The organic electroluminescent emission unit 192 may include a low molecular weight organic layer or a polymer organic layer. For example, the low molecular weight organic layer may be a hole injection layer (HIL), a hole transport layer (HTL), an organic emission layer (EML), an electron transport layer (ETL), an electron injection layer (EIL), a combination of these, or the like can be used. The organic layer may be made of copper phthalocyanine (CuPc), N,N'-Di(naphthalene-1-yl)-N,N'-diphenyl-benzidine (NPB), tris-8-hydroxyquinoline aluminum (Alq3), or the like. The low molecular weight organic layer may be formed by a vacuum deposition process.

When the organic electroluminescent emission unit 192 includes a polymer organic layer, the polymer organic layer may include a HTL and an EML. The HTL may be made of PEDOT, and the EML may be made of Poly-Phenylenevinylenes (PPVs), polyfluorenes, or the like. The polymer organic layer may be formed by a screen printing process, an inkjet printing process, or the like.

A second electrode layer 210 operating as a cathode electrode may be arranged on the upper surface of the organic electroluminescent unit 192. However, the location of the second electrode layer 210 is not limited thereto. The second electrode layer 210 may be made of Al/Ca, ITO, Mg-Ag, or the like, according to the emission type of the electroluminescent display device. However, because the second electrode layer 210 may include a plurality of layers, the second electrode layer 210 may also include an alkali layer made of LiF or the like, or an alkali earth metal fluoride layer.

FIG. 2D is a sectional view taken along line II - II shown in FIG. 2A. Referring to FIG. 2D, a width w2 of the encapsulant 310 of the organic electroluminescnece display device is greater than a width of the encapsulant 30 of the conventional electroluminescent display device shown in FIG. 1B.

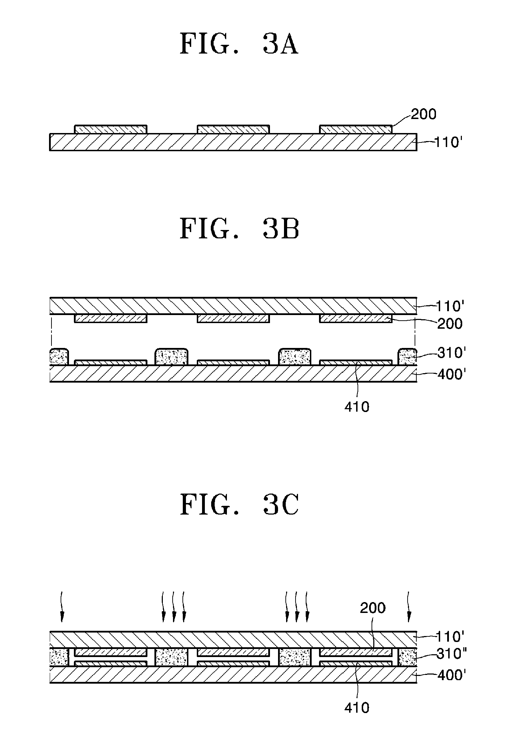

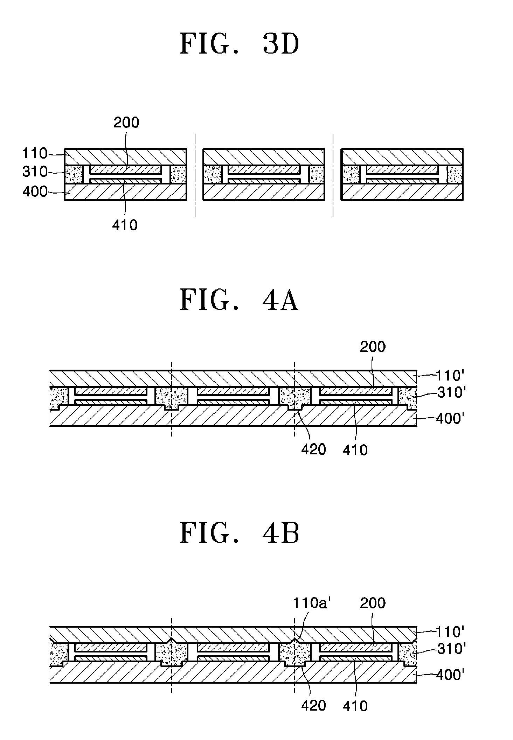

FIGS. 3A, 3B, 3C, and 3D are sectional views showing a method of manufacturing the organic electroluminescent display device illustrated in FIG. 2A. Referring to FIG. 3A, at least one display region 200 is arranged on an upper surface of a mother substrate 100'.

Referring to FIG. 3B, an absorbing layer 410 and an encapsulant 310' are arranged on a sealing mother substrate 400'. The encapsulant 310' that is formed on the sealing mother substrate 400' covers at least a portion of a scribing region.

Referring to FIG. 3C, after forming the encapsulant 310', the encapsulant 310'is hardened by a hardening process, such as UV radiation, thermal radiation, or the like, thus forming a hardened encapsulant 310".

Referring to FIG. 3D, the resulting structure is scribed, e.g., cut, along the scribing region. Therefore, the mother substrate 110' and sealing mother substrate 400'are divided into organic electroluiminescent display devices, each including a substrate 110 and a sealing substrate 400.

According to another embodiment of the invention, a recess may be formed at an edge region of a substrate and/or a sealing substrate where an encapsulant is to be disposed. The recess simplifies the manufacturing process.

FIG. 4A is a sectional view showing methods of manufacturing organic electroluminescent display devices having edges regions with recesses where encapsulants are to be formed.

Referring to FIG. 4A, a mother substrate 110' faces a sealing mother substrate 400 The mother substrate 110' and the sealing mother substrate 400'are sealed by an encapsulant 300'that is not yet hardened. A display region 200 is then formed on a surface of the mother substrate 100', and an absorbing layer 410 is then formed on a surface of the sealing mother substrate 400'.

A portion of the surface of the sealing substrate 400'where the encapsulant 300'is to be formed includes a recess 420. The recess 420 prevents the encapsulant 300'that is not yet hardened from flowing or releasing into an adjacent display region 200. The recess 420 directs stress applied to the sealing mother substrate 400'during a scribing process toward the recess 420. Therefore, the risk of damaging the mother sealing substrate 400' is reduced, e.g., cracking is reduced.

The recess 420 of the sealing mother substrate 400'may have a substantially rectangular shape, as shown in FIG. 4A; however, the recess is not limited to such shape. Manufacturing the recess 420 is easier when a side surface of the recess 420 is substantially perpendicular to a surface of the mother sealing substrate 400'that is to be divided by scribing. However, it is understood that the recess 420 may have various shapes. For example, the width of the recess 420 may widen near the upper surface of the mother sealing substrate 400' so that stress applied to the recess 420 is more focused at scribing region.

In addition, a recess may be formed at an edge of an individual display device that is manufactured by scribing of a substrate. For example, referring to FIG. 4B, a mother substrate recess 110a is formed at a portion of a mother substrate 110' corresponding to the recess 420 formed in the sealing mother substrate 400'.

In addition, the recess may be formed continuous or discontinuous along an edge where an encapsulant is formed. When the recess is continuously formed, excellent processing properties are obtained. Alternatively, when the recess is discontinuous formed, the risk of damaging the mother substrate and/or the sealing mother substrate is reduced because the weight, e.g., force, of the mother substrate and/or the sealing mother substrate is focused toward the recess.

Although several embodiments of the invention are described and shown above, such embodiments are not intended to limit the scope of the invention. For example, although AM-type organic electroluminescent display devices are shown in the embodiments, the invention can also be applied to inorganic electroluminescent display devices, PM type electroluminescent display devices, and the like.

According to the present invention, the following effects can be obtained.

Moisture and/or oxygen leakage in a sealed space of the display device may be reduced or prevented by disposing an encapsulant on at least a portion of an edge of a substrate such that a region where the encapsulant is disposed may be increased..

Cracks that may generate in a display region may be decreased or prevented by forming a recess on a substrate and/or a sealing substrate such that overflowing of the encapsulant into a display region when the encapsulant is formed may be prevented.

It will be apparent to those skilled in the art that various modifications and variation can be made in the present invention without departing from the spirit or scope of the invention. Thus, it is intended that the present invention cover the modifications and variations of this invention provided they come within the scope of the appended claims and their equivalents.

## Claims

1. An electroluminescent display device, comprising:
a substrate comprising a display region and a terminal unit;
a sealing substrate arranged above the substrate; and
an encapsulant arranged at edge regions of the substrate and the sealing substrate, and sealed with the display region.

2. The electroluminescent display device of claim 1, wherein the edge regions where the encapsulant is arranged are positioned to face each other.

3. The electroluminescent display device of claim 1, wherein an edge region of the substrate and/or the sealing substrate on which the encapsulant is formed comprises a recess.

4. The electroluminescent display device of claim 3, wherein the recess is discontinuous along the edge region where the encapsulant is arranged.

5. The electroluminescent display device of claim 3, wherein the recess is continuous along the edge region where the encapsulant is arranged.

6. The electroluminescent display device of claim 3, wherein a side surface of the recess is substantially perpendicular to the surface of the substrate and/or the sealing substrate.

7. The electroluminescent display device of claim 3, wherein the recess widens toward the surface of the substrate and/or the sealing substrate.

8. A method of manufacturing an electroluminescent display device, comprising:
forming a display region on a mother substrate;
forming an encapsulant on a portion of a scribed region on a sealing mother substrate;
hardening the encapsulant;
sealing the mother substrate with the sealing mother substrate; and
cutting the mother substrate and the sealing mother substrate along the scribing region.

9. The method of claim 8, further comprising:
forming a recess in a portion of the scribed region of the mother substrate before forming the display region.

10. The method of claim 9, wherein the recess is continuous along a region where the encapsulant is formed on the mother substrate.

11. The method of claim 9, wherein the recess is discontinuous along a region where the encapsulant is formed on the mother substrate.

12. The method of claim 9, wherein a side surface of the recess is substantially perpendicular to a surface of the mother substrate and/or the mother sealing substrate.

13. The method of claim 9, wherein the recess widens toward a surface of the mother substrate.

14. The method of claim 8, further comprising:
forming a recess at a portion of a scribed region of the sealing mother substrate before forming the encapsulant.

15. The method of claim 14, wherein the recess is continuous along a region where the encapsulant is formed on the sealing mother substrate.

16. The method of claim 14, wherein the recess is discontinuous along a region where the encapsulant is formed on the sealing mother substrate.

17. The method of claim 14, wherein a side surface of the recess is substantially perpendicular to a surface of the mother substrate and/or the mother sealing substrate.

18. The method of claim 14, wherein the recess widens toward the surface of the sealing mother substrate.
